# EUROPEAN PATENT SPECIFICATION

(11) **EP 2 096 449 B1**
(45) Date of publication and mention of the grant of the patent: **27.02.2013**
(21) Application number: 08152127.0
(22) Date of filing: 29.02.2008
(51) Int. Cl.: H05K 1/11, G01R 3/00

(54) **Testbed for testing electronic circuits and components**
Testbett zum Testen elektronischer Schaltungen und Baugruppen
Banc d'essai pour tester des circuits électroniques et des composants

(43) Date of publication of application: 02.09.2009
(73) Proprietor: Research In Motion Limited, Waterloo, ON N2L 3W8 (CA)
(72) Inventor: Carney, Michael, Waterloo Ontario N2L 3W8 (CA); Reksnis, Marek, Waterloo Ontario N2L 3W8 (CA); Toth, Ted, Waterloo Ontario N2L 3W8 (CA)
(74) Representative: MERH-IP Matias Erny Reichl Hoffmann

(56) References cited:
- EP-A- 0 677 985
- US-A- 4 628 409
- US-A- 5 068 602
- US-A- 5 736 279
- US-A- 5 823 818
- US-B1- 6 661 245

## Description

The present invention relates generally to a testbed for testing electronic circuits and components.

In electronics assembly and manufacturing, a printed circuit board (PCB) is often used to lay down electrical circuits and to provide a base for mounting various types of electronic components. The circuits in the PCBs may comprise electrically conductive pathways traced or etched from conductive material (e.g. copper sheets) onto a non-conductive substrate. Multiple layers of these conductive pathways may be separated by alternating layers of non-conductive substrates in order to form a laminate board that may include many layers of circuits and non-conductive substrates.

In order to connect the circuits in one or more of the conductive layers, via-holes may be drilled into the laminate layers of the PCB. Once the via-hole is formed, the inner walls of the holes are plated with copper or another conductive material such that any overlapping conductive pathways located at the point of the via-hole are electrically connected between layers. The depth of the drilling may be controlled to connect only some of the layers in the PCB, or the via-hole may be drilled through the laminate board to provide an opening from one side of the board to the other.

Components are then placed on the PCB at predetermined connection points provided on the outer surfaces of the PCB in order to build various parts of the circuit required for the designed operation of the electronic device. Generally speaking, electronic components with leads are attached to the PCB at connection points defined by conductive landing pad extensions or connectors provided on the surface of the PCB to receive the component leads. For electronic components that are to be permanently attached to the PCB, the electrical and mechanical connections between the component leads and the conductive landing pad extensions may be made using a suitable soldering paste or compound.

Once a stage of assembly has been completed, an electronic device under test (DUT) may be tested on a testbed to ensure that the electrical connections and pathways have been properly assembled to that point. To ensure a proper test, the testbed must be properly configured.

US-A-5068602 discloses a reconfigurable device under test (DUT) board having inner and outer arrays of holes passing through the board and containing sockets. The sockets of the inner array receive pins of a device under test and each socket of the outer array is connected to either a signal run or a grounded connection run within the board. The rear of each socket of the inner array and each ungrounded socket of the outer array has a pin which forms a coaxial contact receptacle so that the pins of the inner and outer arrays can be reconfigurably interconnected by coaxial jumpers.

US-A-4628409 discloses a printed circuit board which facilitates removal and replacement of components. The circuit board has unplated holes extending therethrough for receiving connection pins of components mounted on one face of the circuit board. The pins protrude from the opposite face of the circuit board and are soldered to conductive pads on this face which are connected by surface conductors to plated through-holes linking conductive tracks at different layers of the circuit board.

### GENERAL

In a first aspect, there may be provided a method of mounting a receptacle for positioning a nail in an electronic testbed board, comprising the steps of:
i) drilling one or more via-holes in the testbed board;
ii) electrically connecting conductive layers at the one or more via-holes by applying a conductive coating to the inner walls of the one or more via-holes;
iii) after step ii) drilling a mounting through-hole for mounting a receptacle adjacent to the one or more via-holes and substantially perpendicular to the testbed board;
iv) mounting a receptacle in the mounting through-hole; and
v) electrically connecting the mounted receptacle to the conductive layers at the one or more via-holes.

In another embodiment, the method may further comprise: providing a conductive landing pad extension at each of the one or more via-holes, the conductive landing pad extension being electrically connected to the conductive layers at the one or more via-ho les.

In another embodiment, the method may further comprise: electrically connecting the mounted receptacle to the conductive layers at the one or more via-holes via the landing pad extensions.

In another embodiment, the method may further comprise: positioning the conductive landing pad extension at each of the one or more via-holes towards an adjacent mounting through-hole, with a gap provided between the conductive landing pad extension and the mounting through-hole; and electrically connecting the mounted receptacle to the conductive layers at the one or more via-holes by soldering the gap between the landing pad extension and the mounted receptacle.

In another embodiment, electrically connecting conductive layers at the one or more via-holes may comprise vapour depositing a coating of copper or other conductive material into the one or more via-holes.

In another aspect, there may be provided an electronic testbed board for mounting a receptacle for positioning a nail, the electronic testbed board comprising: a mounting through-hole for mounting a receptacle, the mounting through-hole having a suitably precise diameter for mounting the receptacle substantially perpendicular to the testbed board; one or more via-holes located adjacent the mounting through-hole, the one or more via-holes adapted to allow an electrical connection between any conductive layers provided at the one or more via-holes, the electrical connection between the conductive layers comprising a conductive coating on the inner walls of the one or more via holes; the inner walls of the mounting through-hole having no conductive coating.

In an embodiment, the electrical connection between any conductive layers provided at the one or more via-holes may be provided by a coating of copper.

In another embodiment, the electronic testbed board may further comprise: a conductive landing pad extension provided at each of the one or more via-holes, the conductive landing pad extensions being electrically connected to the any conductive layers provided at the one or more via-holes.

In another embodiment, the conductive landing pad extensions provided at each of the one or more via-holes may be positioned towards the mounting through-hole, with a gap provided between the conductive landing pad extensions and the mounting through-hole.

In another embodiment, the electronic testbed board may further comprise: a receptacle mounted in the mounting through-hole; and an electrical conductor closing the gap provided between the conductive landing pad extensions and the receptacle mounted in the mounting through-hole.

In another embodiment, the electrical conductor may be a bead of solder electrically connecting the conductive landing pad extensions to an exposed base of the receptacle mounted in the mounting through-hole.

In another embodiment, the mounting through-hole for mounting a receptacle may be formed by mechanical drilling with a drill bit.

In another embodiment, the diameter of the mounting through-hole for mounting a receptacle may be drilled to a suitably precise diameter for mounting the receptacle without play.

In another aspect, there may be provided an electronic testbed, comprising: the electronic testbed board according to the first aspect, and further comprising: at least one nail in a receptacle mounted in the mounting through-hole in the electronic testbed board; and an electrical connection provided between any conductive layers at the one or more via-holes and the at least one nail in a receptacle mounted in the mounting through-hole.

### BRIEF DESCRIPTION OF THE DRAWINGS

In the figures which illustrate exemplary embodiments:
FIG. 1 is a perspective view of a portion of a testbed having a plurality of nails provided thereon;
FIG. 2A is an enlarged perspective view of two of the nails that have been positioned incorrectly;
FIG. 2B is a schematic cross-section of the perspective view in FIG. 2A taken at 2B-2B;
FIG. 3 is an enlarged schematic cross-section of the base of one of the nails of FIGS. 2A & 2B;
FIG. 4A is a schematic cross-section of an arrangement for positioning and aligning nails in a test bed in accordance with an embodiment;
FIG. 4B is a top view of the cross-sectional view of FIG. 4A;
FIG. 4C is the schematic cross-section view of FIG. 4A of an arrangement for electrically connecting receptacles for nails to the testbest in accordance with another embodiment;
FIG. 4D is a top view of the cross-sectional view of FIG. 4C; and
FIG. 5 is a schematic flowchart of a method in accordance with an embodiment.

### DESCRIPTION OF PREFERRED EMBODIMENTS

As noted above, the present invention relates to a testbed for testing electronic circuits and components.

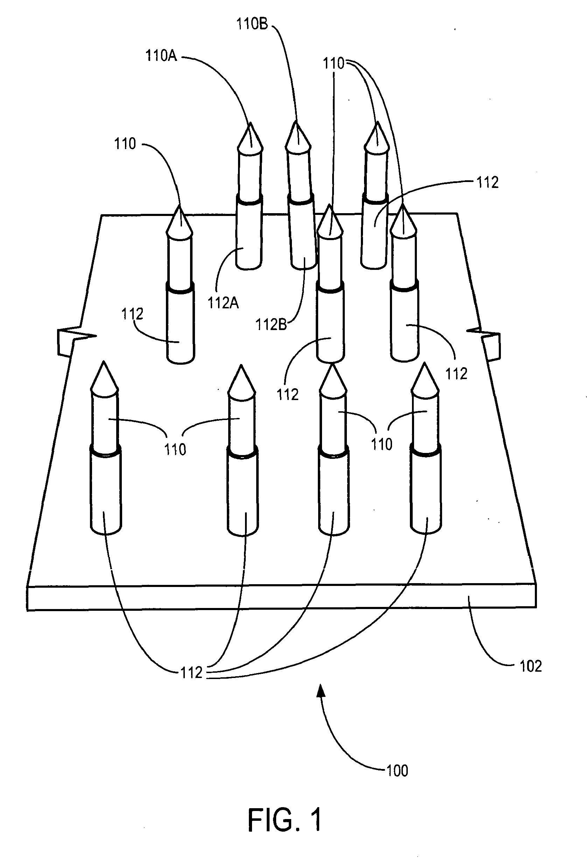

Referring to FIG. 1, shown is a portion of a testbed platform 100 which may be used to electrically probe a DUT or device under test. As shown, this may be achieved by positioning a plurality of nails 110 at various locations in the testbed board 102. These nails may be positioned at their intended locations by using receptacles 112 mounted and soldered into position in via-holes in the testbed board 102. Each nail 110 may be spring mounted in a receptacle 112 such that the overall height of the nails 110 as measured from the testbed board 102 may be adjusted for making proper contact with the probe points of a DUT.

In order to conduct a proper test, the testbed platform 100 must be properly configured, and the nails 110 must be accurately positioned within the testbed board 102. Heretofore, via-holes have been drilled with a larger diameter than is necessary for the diameter of receptacles 112, and then coated with copper or other conductive materials to provide an electrical connection between layers of the testbed plate 102. The copper or other conductive material is typically applied at the via-holes using a metallic vapour depositing process, and is built up to a suitable thickness to provide both an electrical connection at the via-holes, and a suitable diameter for the receptacles 112. However, due to manufacturing and processing variations, the thickness of the copper or other conductive material built up in the via-holes may vary. The resulting diameter of the copper coated via-holes may thus vary, and the via-holes may sometimes be too large or too small for the diameter of the receptacles 112.

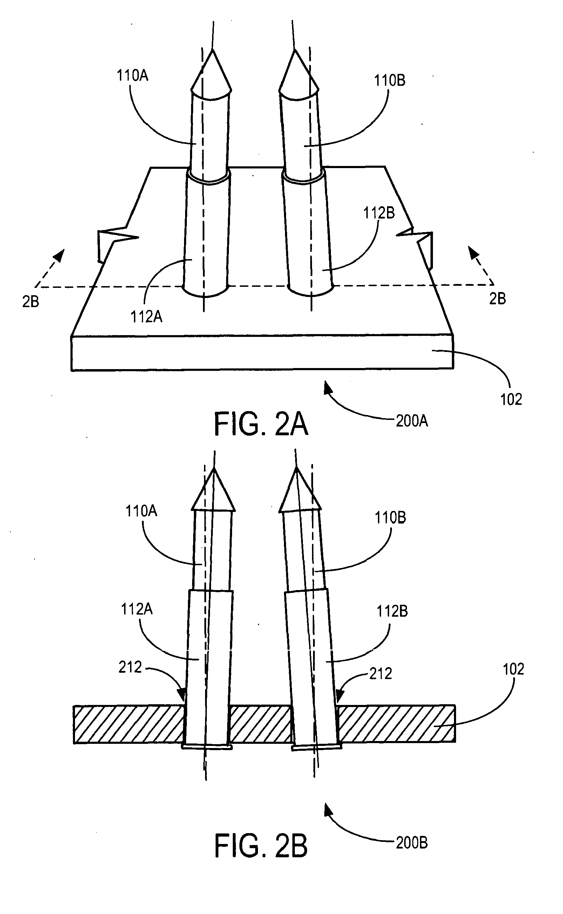

Now referring to FIG. 2A and FIG. 2B, shown in FIG. 2A are illustrative examples of two nails 110A and 110B that have been incorrectly positioned in the testbed board 102 for testing, as the tips of both nails 110A and 110B are significantly offset from their intended positions. FIG. 2B shows a cross-sectional view of FIG. 2A taken at 2B-2B, which more clearly illustrates that the receptacles 112A and 112B are mounted through the via-holes 212, at slight angles from vertical.

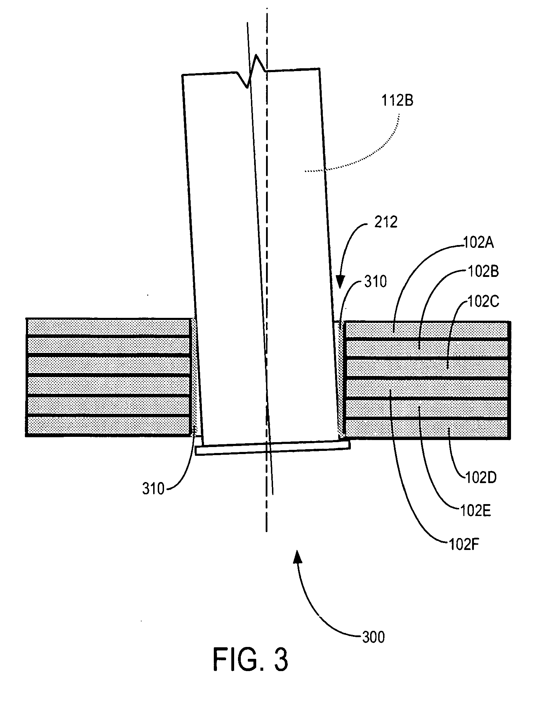

FIG. 3 shows in more detail the incorrect positioning of receptacle 112B, in this case due to too much play in the via-hole 212. For example, this may have resulted from not enough copper coating 310 being deposited on the inside surface of the via-hole 212, resulting in the copper coating 310 being too thin for properly positioning the receptacle 112B in the via-hole 212. FIG. 3 also illustrates the individual layers 102A-102F of the testbed board 102 that may be electrically connected by the copper coating 310.

Still referring to FIG. 3, while the angle offset of the receptacle 112B may be slight, the tips of the nails 110A and 110B that must contact the probe points in a DUT (not shown) may be significantly offset from their intended locations for probing the DUT. This may cause inaccurate testing of a DUT placed on the testbed platform 100, resulting in good DUTs being sent back for re-work, or even possibly bad DUTs being accepted and passed through.

If a bad testbed platform 100 is discovered, remedial action that may be taken on the testbed platform 100 often involves difficult resoldering of the nail and receptacle, or complete re-fabrication of the entire testbed platform which may be very expensive.

To address the above identified problems, as will now be explained, the inventors have come up with a new way to mount the receptacles 112 for the nails 110 in the testbed board 102 which significantly improves the accuracy of the positioning of the nails 110 for receiving and probing a DUT.

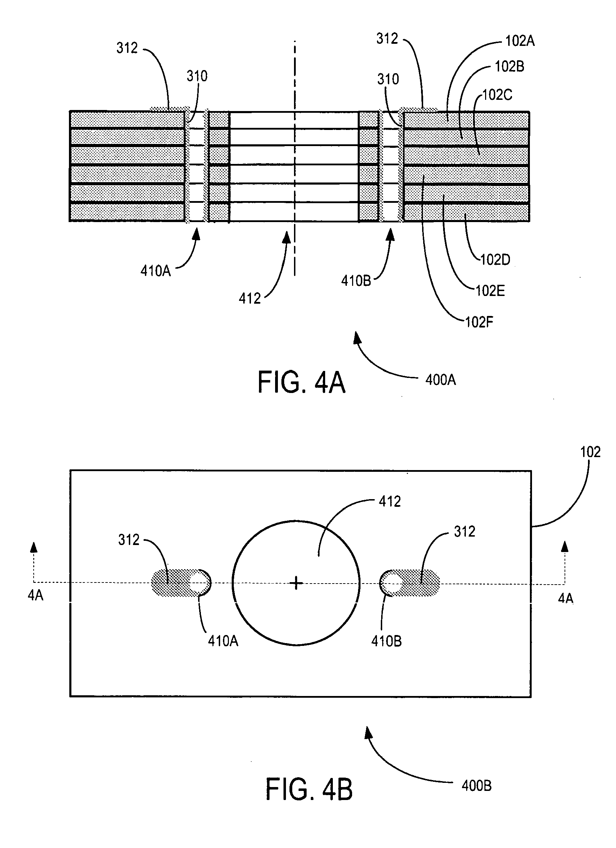

Now referring to FIG. 4A, shown is a cross-sectional view of an arrangement for positioning and aligning nails 110, and receptacles 112 for the nails 110 in a testbed board 102 in accordance with an illustrative embodiment. FIG. 4B shows a corresponding top view of FIG. 4A, with the viewing plane of the cross-sectional view of FIG. 4A shown in FIG. 4B at 4A-4A. As shown, instead of having a via-hole 212 that is drilled with a larger diameter than is required for a receptacle, and which is then coated with copper or other conductive material built up to a suitable thickness, there are now a plurality of holes that serve different functions. More specifically, a mounting through-hole 412 is now provided which is precisely drilled to a suitable diameter for mounting a receptacle 112 substantially perpendicular to the testbed board 102. Now, instead of depositing copper or other conductive material on the walls of through-hole 412 to provide an electrical connection between the layers, one or more adjacent via-holes 410A, 410B are specifically adapted to provide an electrical connection between the layers 102A-102F, using a copper coating 310 or a coating of another suitable conductive material. By way of example, in a typical embodiment, the adjacent via-holes 410A, 410B may be drilled a few millimeters from the through-hole 412 and should be of sufficient distance to ensure mechanical strength of the through-hole 412. The diameter of the via-holes 410A, 410B should be of sufficient size to ensure that an electrical connection can be made reliably through the testbed board 102. Generally speaking, the thicker the testbed board 102, the larger the diameter of the via-holes 410A, 410B need to be to ensure reliable plating.

In an embodiment, drilling may encompass any technique for making a hole that is suitably precise to provide an accurate fit for a receptacle 112 in the mounting through-hole 412, such that the receptacle 112 is substantially perpendicular to the testbed board 102. However, when drilling the testbed board 102 using a drill bit to create the mounting through-hole 412, it is preferable that no conductive plating should be present where the drill will create the mounting through-hole 412. This is because, during the drilling of the mounting through-hole 412, the presence of conductive plating may result in a drill bit possibly destroying the conductive plating, either by lifting the conductive plating off the board, or breaking it up, such that in either case the connection with the opposite-side circuit may be broken.

As the adjacent via-holes 410A and 410B no longer need to receive a receptacle 112, the via-holes 410A and 410B may also be made smaller, and the thickness of the copper coating 310 may vary within a relaxed range of tolerance. Furthermore, the via-holes 410A and 410B need not be drilled all the way through. Instead, each of the via-holes 410A and 410B may be drilled to different depths, if appropriate, to connect certain layers 102A-102F of the testbed board 102, at possibly more than one connection point in each layer.

Also, suitable conductive landing pad extensions 312 may be provided at the location of the via-holes 410A, 410B to provide a suitable location for an electrical connection for the receptacles 112 or nails 110. For example, a receptacle 112 mounted in position in the mounting through-hole 412 may be electrically connected to the conductive landing pad extension 312 using a lead wire and some solder (not shown).

As will be appreciated, by separating the electrical and mechanical functions using multiple holes 410A, 410B, 412, the accuracy in positioning the receptacles 112 (and therefore the nails 110 mounted in place in the receptacles 112), can be greatly improved. That is, the receptacles 112 may be mounted in a substantially perpendicular position relative to the electronic testbed board 102, and without play, such that the nails 110 can be placed more accurately in their intended positions for contacting the probe contact points of a DUT. As well, as it is no longer necessary to control the thickness of the copper 310 as carefully as before, the success rate in manufacturing an accurately functioning testbed platform may also be significantly improved.

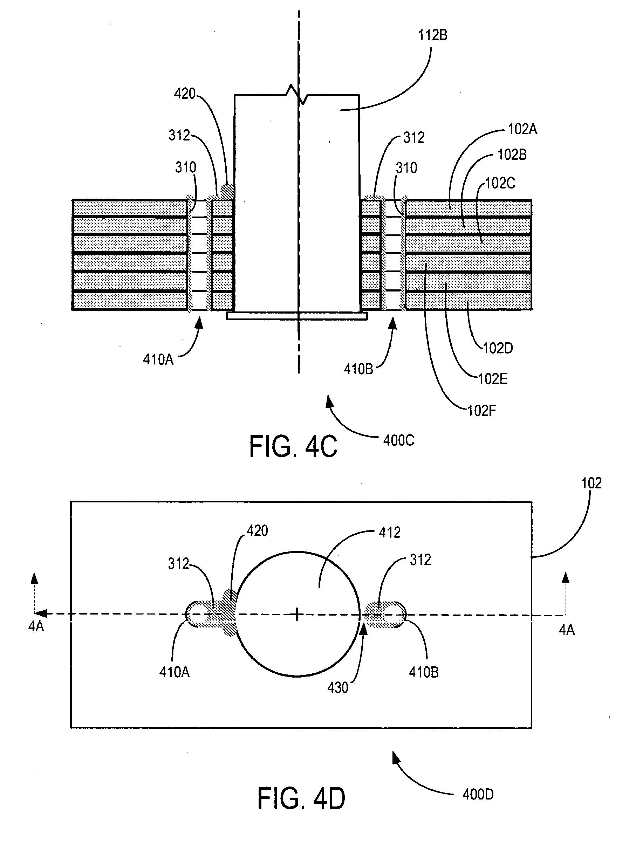

Now referring to FIG. 4C and FIG. 4D, shown is an alternative embodiment for connecting the base of a receptacle (e.g. receptacle 112B) to one or more of the via-holes 410A, 410B. As shown, the conductive landing pad extensions 312 provided at the via-holes 410A, 410B may be positioned towards the mounting through-hole 412. However, to avoid the problem of lifting the copper coating as described earlier, a suitable clearance or gap 430 may be provided between the conductive landing pad extension 312 and the mounting through-hole 412. Once the mounting through-hole 412 has been drilled, and a receptacle 112B has been suitably positioned in the mounting through-hole 412, a bead of solder 420 may be provided to close the clearance 430, thereby providing an electrical connection between the conductive landing pad extension 312 and an exposed base of the receptacle 112B. Therefore, the clearance or gap 430 should be kept to a small distance in order to provide ease of bridging the clearance or gap with the bead of solder 420. It will be appreciated that this way of connecting the receptacle 112B to one or more of the via-holes 410A, 410B avoids having to use a lead wire between the conductive landing pad extension 312 and the receptacle 112B. Also, the additional soldering may provide additional stability to the receptacle 112B mounted in the testbed board 102.

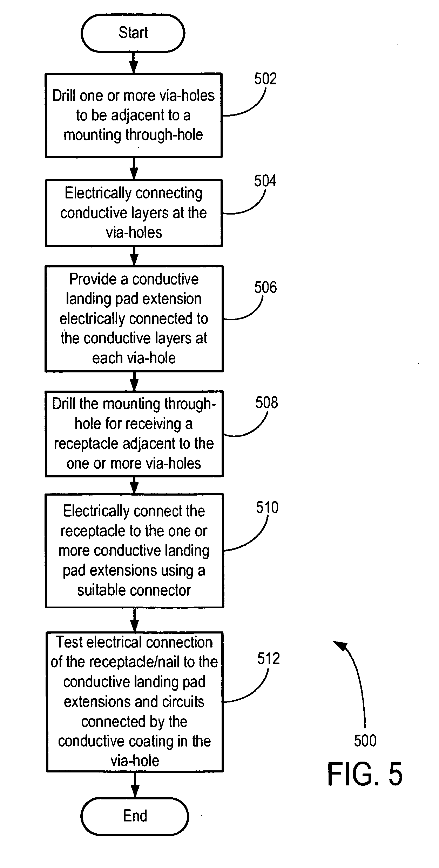

Now referring to FIG. 5, shown is a flowchart of an illustrative method 500 in accordance with an embodiment. The processes may be, but need not be performed in the order shown in FIG. 5. As shown, method 500 begins and at block 502 drills one or more via-holes to be adjacent to a mounting through-hole.

In an embodiment, the via-holes are drilled before the mounting through-hole is drilled, such that at block 504 method 500 can electrically connect conductive layers at the via-holes. For example, the conductive layers may be electrically connected by coating the inner walls of one or more via-holes with copper or another conductive coating. Alternatively, a solid connector such as a copper insert may be inserted into the via-holes.

Method 500 may then proceed to block 506, where method 500 provides for each via-hole a conductive landing pad extension electrically connected to the conductive layers at each via-hole. As noted earlier, in an embodiment, the conductive landing pads may be positioned towards the mounting through-hole with a suitable clearance.

Method 500 may then proceed to block 508, where method 500 drills the mounting through-hole for receiving a receptacle. As the mounting through-hole need not go through a conductive coating process, the diameter of the mounting through-hole may be drilled more precisely and substantially perpendicular to the testbed board to accommodate the diameter of the receptacle to be mounted in the mounting through-hole.

Method 500 may then proceed to block 510, where method 500 may electrically connect the receptacle to the one or more conductive landing pad extensions using a suitable connector. For example, the suitable connector may be a lead wire that is bonded to the conductive landing pad extension and to the receptacle using solder or an ultrasonic wire bonding machine. Alternatively, if the conductive landing pad extension is properly positioned towards the main thorough hole with a suitable clearance or gap that is provided, solder may be used to bridge the clearance or gap in order to provide an electrical connection between the conductive landing pad extension and a receptacle mounted in the mounting through-hole.

Method 500 may then proceed to block 512, where method 500 may test the electrical connection of the receptacle (and/or the nail spring mounted in the receptacle) to the conductive landing pad extension and any circuits connected by the conductive coating in the via-holes. Method 500 then ends.

While illustrative embodiments have been described above, it will be appreciated that various changes and modifications may be made. More generally, the scope of the invention is defined by the following claims.

## Claims

1. A method of mounting a receptacle (112) for positioning a nail (110) in an electronic testbed board (102), comprising the steps of:
i) drilling one or more via-holes (410) in the testbed board (102);
ii) electrically connecting conductive layers of the testbed board (102) at the one or more via-holes (410) by applying a conductive coating (310) to the inner walls of the one or more via-holes (410);
iii) after step ii) drilling a mounting through-hole (412) for mounting a receptacle (112) adjacent to the one or more via-holes (410) and substantially perpendicular to the testbed board (102);
iv) mounting a receptacle (112) in the mounting through-hole (412), the inner walls of the mounting through-hole (412) having no conductive coating; and
v) electrically connecting the mounted receptacle (112) to the conductive layers at the one or more via-holes (410).

2. The method of claim 1, further comprising:
providing a conductive landing pad extension (312) at each of the one or more via-holes (410), the conductive landing pad extension (312) being electrically connected to the conductive layers at the one or more via-holes (410).

3. The method of claim 2, further comprising:
electrically connecting the mounted receptacle (112) to the conductive layers at the one or more via-holes (410) via the landing pad extensions (312).

4. The method of claim 3, further comprising:
positioning the conductive landing pad extension (312) at each of the one or more via-holes (410) towards an adjacent mounting through-hole (412), with a gap (430) provided between the conductive landing pad extension (312) and the mounting through-hole (412); and
electrically connecting the mounted receptacle (112) to the conductive layers at the one or more via-holes (410) by soldering the gap (430) between the landing pad extension (312) and the mounted receptacle (112).

5. The method of any one of claims 1 to 4, wherein electrically connecting conductive layers at the one or more via-holes (410) comprises vapour depositing a coating of copper or other conductive material into the one or more via-holes (410).

6. An electronic testbed board (102) for mounting a receptacle (112) for positioning a nail (110), the electronic testbed board (102) comprising:
at least one receptacle (112);
a mounting through-hole (412) for mounting the receptacle (112), the mounting through-hole (412) having a suitably precise diameter for mounting the receptacle (112) substantially perpendicular to the testbed board (102);
one or more via-holes (410) located adjacent the mounting through-hole (412), the one or more via-holes (410) adapted to allow an electrical connection between any conductive layers of the testbed board (102) provided at the one or more via-holes (410), the electrical connection between the conductive layers comprising a conductive coating (310) on the inner walls of the one or more via-holes (410);
the inner walls of the mounting through-hole (412) having no conductive coating,
wherein the mounted receptacle (112) is electrically connected to the conductive layers at the one or more via-holes (410).

7. The electronic testbed board (102) of claim 6, wherein the electrical connection between the conductive layers provided at the one or more via-holes (410) comprises a coating (310) of copper.

8. The electronic testbed board (102) of claim 6 or claim 7, further comprising:
a conductive landing pad extension (312) provided at each of the one or more via-holes (410), the conductive landing pad extensions (312) being electrically connected to the conductive layers provided at the one or more via-holes (410).

9. The electronic testbed board (102) of claim 8, wherein the conductive landing pad extensions (312) provided at each of the one or more via-holes (410) are positioned towards the mounting through-hole (412), with a gap (430) provided between the conductive landing pad extensions (312) and the mounting through-hole (412).

10. The electronic testbed board (102) of claim 9, further comprising:
a receptacle (112) mounted in the mounting through-hole (412); and
an electrical conductor (420) closing the gap (430) provided between the conductive landing pad extensions (312) and the receptacle (112) mounted in the mounting through-hale (412).

11. The electronic testbed board (202) of claim 10, wherein the electrical conductors (420) is a bead of solder electrically connecting the conductive landing pad extensions (312) to an exposed base of the receptacle (112) mounted in the mounting through-hole (412).

12. The electronic testbed board (102) of any one of claims 6 to 11, wherein the mounting through-hole (412) for mounting a receptacle (112) is formed by mechanical drilling with a drill bit,

13. The electronic testbed board (102) of claim 12, wherein the diameter of the mounting through-hole (412) for mounting a receptacle (112) is drilled to a suitably precise diameter for mounting the receptacle (112) without play.

14. An electronic testbed comprising the electronic testbed board (102) according to any one of claims 6 to 11, and further comprising:
at least one nail (110) in the receptacle (112) mounted in the mounting through- H hole (412) of the electronic testbed board (102); and
an electrical connection provided between any conductive layers at the one or more via-holes (410) and the at least one nail (110) in the receptacle (112) mounted in the mounting through-hole (412).

## Patentansprüche

1. Ein Verfahren zum Anbringen einer Aufnahmevorrichtung (112) zum Positionieren eines Stifts (110) in einer elektronischen Testumgebungsplatte (102), das die Schritte aufweist:
i) Bohren eines Durchgangslochs oder mehrerer Durchgangslöcher (410) in die Testumgebungsplatte (102);
ii) elektrisches Verbinden von leitenden Schichten der Testumgebungsplatte (102) an dem einen Durchgangsloch oder den mehreren Durchgangslöchern (410) durch Aufbringen einer leitenden Beschichtung (310) auf die inneren Wände des einen Durchgangslochs oder der mehreren Durchgangslöcher (410);
iii) nach dem Schritt ii) Bohren eines Befestigungs-Durchgangslochs (412) zum Anbringen einer Aufnahmevorrichtung (112) angrenzend an das eine Durchgangsloch oder die mehreren Durchgangslöcher (410) und im Wesentlichen senkrecht zu der Testumgebungsplatte (102);
iv) Anbringen einer Aufnahmevorrichtung (112) in dem Befestigungs-Durchgangsloch (412), wobei die inneren Wände des Befestigungs-Durchgangslochs (412) keine leitende Beschichtung haben; und
v) elektrisches Verbinden der angebrachten Aufnahmevorrichtung (112) mit den leitenden Schichten an dem einen Durchgangsloch oder den mehreren Durchgangslöchern (410).

2. Das Verfahren gemäß Anspruch 1, das weiter aufweist:
Vorsehen einer leitenden Auftrefffläche-Erweiterung (312) an jedem des einen oder der mehreren Durchgangslöcher (410), wobei die leitende Auftrefffläche-Erweiterung (312) elektrisch mit den leitenden Schichten an dem einen oder den mehreren Durchgangslöchern (410) verbunden ist.

3. Das Verfahren gemäß Anspruch 2, das weiter aufweist:
elektrisches Verbinden der angebrachten Aufnahmevorrichtung (112) mit den leitenden Schichten an dem einen oder den mehreren Durchgangslöchern (410) über die Auftrefffläche-Erweiterungen (312).

4. Das Verfahren gemäß Anspruch 3, das weiter aufweist:
Positionieren der leitenden Auftrefffläche-Erweiterung (312) an jedem des einen oder der mehreren Durchgangslöcher (410) in Richtung eines angrenzenden Befestigungs-Durchgangslochs (412), mit einer Lücke (430) zwischen der leitenden Auftrefffläche-Erweiterung (312) und dem Befestigungs-Durchgangsloch (412); und
elektrisches Verbinden der angebrachten Aufnahmevorrichtung (112) mit den leitenden Schichten an dem einen oder den mehreren Durchgangslöchern (410) durch Löten der Lücke (430) zwischen der Auftrefffläche-Erweiterung (312) und der angebrachten Aufnahmevorrichtung (112).

5. Das Verfahren gemäß einem der Ansprüche 1 bis 4, wobei das elektrische Verbinden der leitenden Schichten an dem einen oder den mehreren Durchgangslöchern (410) aufweist ein Aufdampfen einer Beschichtung aus Kupfer oder einem anderen leitenden Material in das eine oder die mehreren Durchgangslöcher (410).

6. Eine elektronische Testumgebungsplatte (102) zum Anbringen einer Aufnahmevorrichtung (112) zum Positionieren eines Stifts (110), wobei die elektronische Testumgebungsplatte (102) aufweist:
zumindest eine Aufnahmevorrichtung (112);
ein Befestigungs-Durchgangsloch (412) zum Anbringen der Aufnahmevorrichtung (112), wobei das Befestigungs-Durchgangsloch (412) einen geeignet präzisen Durchmesser hat zum Anbringen der Aufnahmevorrichtung (112) im Wesentlichen senkrecht zu der Testumgebungsplatte (102);
ein oder mehrere Durchgangslöcher (410), die sich angrenzend an das Befestigungs-Durchgangsloch (412) befinden, wobei das eine oder die mehreren Durchgangslöcher (410) ausgebildet ist/sind zum Ermöglichen einer elektrischen Verbindung zwischen leitenden Schichten der Testumgebungsplatte (102), die an dem einen oder den mehreren Durchgangslöchern (410) vorgesehen sind, wobei die elektrische Verbindung zwischen den leitenden Schichten eine leitende Beschichtung (310) auf den inneren Wänden des einen oder der mehreren Durchgangslöcher (410) aufweist;
wobei die inneren Wände des Befestigungs-Durchgangslochs (412) keine leitende Beschichtung haben,
wobei die angebrachte Aufnahmevorrichtung (112) mit den leitenden Schichten an dem einen oder den mehreren Durchgangslöchern (410) elektrisch verbunden ist.

7. Die elektronische Testumgebungsplatte (102) gemäß Anspruch 6, wobei die elektrische Verbindung zwischen den leitenden Schichten, die an dem einen oder den mehreren Durchgangslöchern (410) vorgesehen sind, eine Beschichtung (310) aus Kupfer aufweist.

8. Die elektronische Testumgebungsplatte (102) gemäß Anspruch 6 oder Anspruch 7, die weiter aufweist:
eine leitende Auftrefiffläche-Erweiterung (312), die an jedem des einen oder
der mehreren Durchgangslöcher (410) vorgesehen ist, wobei die leitende Auftrefffläche-Erweiterung (312) elektrisch mit den leitenden Schichten verbunden ist, die an dem einen oder den mehreren Durchgangslöchern (410) vorgesehen sind.

9. Die elektronische Testumgebungsplatte (102) gemäß Anspruch 8, wobei die leitenden Auftrefffläche-Erweiterungen (312), die an jedem des einen oder der mehreren Durchgangslöcher (410) vorgesehen sind, in Richtung des Befestigungs-Durchgangslochs (412) positioniert sind, mit einer Lücke (430) zwischen den leitenden Auftrefffläche-Erweiterungen (312) und dem Befestigungs-Durchgangsloch (412).

10. Die elektronische Testumgebungsplatte (102) gemäß Anspruch 9, die weiter aufweist:
eine Aufnahmevorrichtung (112), die in dem Befestigungs-Durchgangsloch (412) angebracht ist; und
ein elektrischer Leiter (420), der die Lücke (430) schließt, die zwischen den leitenden Auftrefffläche-Erweiterungen (312) und der Aufnahmevorrichtung (112) vorgesehen ist, die in dem Befestigungs-Durchgangsloch (412) angebracht ist.

11. Die elektronische Testumgebungsplatte (102) gemäß Anspruch 10, wobei der elektrische Leiter (420) eine Lötperle ist, die die leitenden Auftrefffläche-Erweiterungen (312) mit einer freiliegenden Basis des Aufnahmevorrichtung (112), die in dem Befestigungs-Durchgangsloch (412) angebracht ist, elektrisch verbindet.

12. Die elektronische Testumgebungsplatte (102) gemäß einem der Ansprüche 6 bis 11, wobei das Befestigungs-Durchgangsloch (412) zum Anbringen einer Aufnahmevorrichtung (112) durch mechanisches Bohren mit einem Bohrer gebildet ist.

13. Die elektronische Testumgebungsplatte (102) gemäß Anspruch 12, wobei der Durchmesser des Befestigungs-Durchgangslochs (412) zum Anbringen einer Aufnahmevorrichtung (112) auf einen geeignet präzisen Durchmesser gebohrt ist, um die Aufnahmevorrichtung (112) ohne Spiel anzubringen.

14. Eine elektronische Testumgebung, die die elektronische Testumgebungsplatte (102) gemäß einem der Ansprüche 6 bis 11 aufweist, und die weiter aufweist:
zumindest einen Stift (110) in der Aufnahmevorrichtung (112), die in dem Befestigungs-Durchgangsloch (412) der elektronischen Testumgebungsplatte (102) angebracht ist; und
eine elektrische Verbindung, die zwischen leitenden Schichten an dem einen oder den mehreren Durchgangslöchern (410) und dem zumindest einen Stift (110) in der Aufnahmevorrichtung (112), die in dem Befestigungs-Durchgangsloch (412) angebracht ist, vorgesehen ist.

## Revendications

1. Procédé de montage d'un réceptacle (112) pour positionner un clou (110) dans une carte de banc d'essai électronique (102), comprenant les étapes consistant à :
i) percer un ou plusieurs trous de passage (410) dans la carte de banc d'essai (102) ;
ii) connecter électriquement des couches conductrices de la carte de banc d'essai (102) auxdits un ou plusieurs trous de passage (410) par l'application d'un revêtement conducteur (310) aux parois intérieures desdits un ou plusieurs trous de passage (410) ;
iii) après l'étape ii), percer un trou traversant de montage (412) pour monter un réceptacle (112) au voisinage desdits un ou plusieurs trous de passage (410) et sensiblement perpendiculairement à la carte de banc d'essai (102) ;
iv) monter un réceptacle (112) dans le trou traversant de montage (412), les parois intérieures du trou traversant de montage (412) ne comportant pas de revêtement conducteur ; et
v) connecter électriquement le réceptacle monté (112) aux couches conductrices au niveau desdits un ou plusieurs trous de passage (410).

2. Procédé selon la revendication 1, comprenant de plues :
la disposition d'une extension de zone de réception conductrice (312) au niveau de chacun desdits un ou plusieurs trous de passage (410), l'extension de zone de réception conductrice (312) étant électriquement connectée aux couches conductrices au niveau desdits un ou plusieurs trous de passage (410).

3. Procédé selon la revendication 2, comprenant de plus :
la connexion électrique du réceptacle monté (112) aux couches conductrices au niveau desdits un ou plusieurs trous de passage (410) par l'intermédiaire des extensions de zone de réception (312).

4. Procédé selon la revendication 3, comprenant de plues :
le positionnement de l'extension de zone de réception conductrice (312) au niveau de chacun desdits un ou plusieurs trous de passage (410) vers un trou traversant de montage adjacent (412), un espace (430) étant prévu entre l'extension de zone de réception conductrice (312) et le trou traversant de montage (412) ;
la connexion électrique du réceptacle monté (112) aux couches conductrices au niveau desdits un ou plusieurs trous de passage (410) par soudage de l'espace (430) entre l'extension de zone de réception (312) et le réceptacle monté (112).

5. Procédé selon l'une quelconque des revendications 1 à 4, dans lequel la connexion électrique de couches conductrices au niveau desdits un ou plusieurs trous de passage (410) comprend un dépôt en phase vapeur d'un revêtement de cuivre ou d'un autre matériau conducteur dans lesdits un ou plusieurs trous de passage (410).

6. Carte de banc d'essai électronique (102) pour monter un réceptacle (112) pour positionner un clou (110), la carte de banc d'essai électronique (102) comprenant :
au moins un réceptacle (112) ;
un trou traversant de montage (412) pour monter le réceptacle (112), le trou traversant de montage (412) ayant un diamètre précis de façon appropriée pour monter le réceptacle (112) de façon sensiblement perpendiculaire à la carte de banc d'essai (102) ;
un ou plusieurs trous de passage (410) disposés au voisinage du trou traversant de montage (412), lesdits un ou plusieurs trous de passage (410) étant conçus de façon à permettre une connexion électrique entre n'importe lesquelles des couches conductrices de la carte de banc d'essai (102) disposée au niveau desdits un ou plusieurs trous de passage (410), la connexion électrique entre les couches conductrices comprenant un revêtement conducteur (310) sur les parois intérieures desdits un ou plusieurs trous de passage (410) ;
les parois intérieures du trou traversant de montage (412) ne comportant pas de revêtement conducteur,
dans lequel le réceptacle monté (112) est électriquement connecté aux couches conductrices au niveau desdits un ou plusieurs trous de passage (410).

7. Carte de banc d'essai électronique (102) selon la revendication 6, dans laquelle la connexion électrique entre les couches conductrices disposées au niveau desdits un ou plusieurs trous de passage (410) comprend un revêtement (310) de cuivre.

8. Carte de banc d'essai électronique (102) selon la revendication 6 ou la revendication 7, comprenant de plus :
une extension de zone de réception conductrice (312) disposée au niveau de chacun desdits un ou plusieurs trous de passage (410), les extensions de zone de réception conductrices (312) étant électriquement connectées aux couches conductrices disposées au niveau desdits un ou plusieurs trous de passage (410).

9. Carte de banc d'essai électronique (102) selon la revendication 8, dans laquelle les extensions de zone de réception conductrices (312) disposées au niveau de chacun desdits un ou plusieurs trous de passage (410) sont positionnées vers le trou traversant de montage (412), un espace (430) étant prévu entre les extensions de zone de réception conductrices (312) et le trou traversant de montage (412).

10. Carte de banc d'essai électronique (102) selon la revendication 9, comprenant de plus :
un réceptacle (112) monté dans le trou traversant de montage (412) ; et
un conducteur électrique (420) fermant l'espace (430) prévu entre les extensions de zone de réception conductrices (312) et le réceptacle (112) monté dans le trou traversant de montage (412).

11. Carte de banc d'essai électronique (102) selon la revendication 10, dans laquelle le conducteur électrique (420) est une perle de soudure connectant électriquement les extensions de zone de réception conductrices (312) à une base exposée du réceptacle (112) monté dans le trou traversant de montage (412).

12. Carte de banc d'essai électronique (102) selon l'une quelconque des revendications 6 à 11, dans laquelle le trou traversant de montage (412) pour monter un réceptacle (112) est formé par perçage mécanique avec une mèche de perçage.

13. Carte de banc d'essai électronique (102) selon la revendication 12, dans lequel le diamètre du trou traversant de montage (412) pour monter un réceptacle (112) est percé à un diamètre précis de façon appropriée pour monter le réceptacle (112) sans jeu.

14. Banc d'essai électronique comprenant la carte de banc d'essai électronique (102) selon l'une quelconque des revendications 6 à 11, et comprenant de plus :
au moins un clou (110) dans le réceptacle (112) monté dans le trou traversant de montage (412) de la carte de banc d'essai électronique (102) ; et
une connexion électrique réalisée entre n'importe lesquelles des couches conductrices au niveau desdits un ou plusieurs trous de passage (410) et l'au moins un clou (110) dans le réceptacle (112) monté dans le trou traversant de montage (412).
